# EUROPEAN PATENT APPLICATION

(11) **EP 2 797 224 A1**
(43) Date of publication of application: **29.10.2014**
(21) Application number: 13275271.8
(22) Date of filing: 29.10.2013
(51) Int. Cl.: H03C 3/09

(54) **PLL direct modulator and frequency gain mismatch compensation method in the modulator**

(30) Priority: 22.04.2013 KR 20130044225
(71) Applicant: Samsung Electro-Mechanics Co., Ltd., Gyeonggi-do (KR)
(72) Inventor: Kim, Myeung Su, 443-743 Gyeonggi-do (KR); Lee, Jae Hyung, 443-743 Gyeonggi-do (KR); Lim, Joon Hyung, 443-743 Gyeonggi-do (KR)
(74) Representative: Powell, Timothy John

(57) **Abstract**

The present invention relates to a PLL direct modulator and a frequency gain mismatch compensation method in the modulator.

A PLL direct modulator in accordance with the present invention includes: a phase-frequency detector (PFD), a charge pump (CP), a loop filter, a voltage-controlled oscillator (VCO), a divider, and a sigma-delta modulator, wherein a frequency gain mismatch compensator is installed between the divider and the VCO to modulate a frequency of the VCO by receiving a frequency signal from the divider and modulation data supplied from the outside.

According to the present invention, it is possible to reduce a frequency gain mismatch in the PLL modulator by compensating the frequency gain mismatch through the frequency gain mismatch compensator.

## Description

### CROSS-REFERENCE TO RELATED APPLICATIONS

Claim and incorporate by reference domestic priority application and foreign priority application as follows:

### "CROSS REFERENCE TO RELATED APPLICATION

This application claims the foreign priority benefit of Korean Patent Application No. 10-2013-0044225, entitled filed April 22, 2013, which is hereby incorporated by reference in its entirety into this application."

### BACKGROUND OF THE INVENTION

### 1. Field of the Invention

The present invention relates to a phase-locked loop (PLL) direct modulator, and more particularly, to a PLL direct modulator that can reduce a frequency gain mismatch by changing a division ratio through a sigma-delta modulator and compensating the frequency gain mismatch through a frequency gain mismatch compensator, and a frequency gain mismatch compensation method in the modulator.

### 2. Description of the Related Art

In recent times, as a minimum line width is reduced to less than tens of nm with the day-to-day development of semiconductor technologies, competiveness of semiconductor chips depend on a chip area. Therefore, in the communication chip market, structures for reducing a chip area have been continuously disclosed in recent years. Among them, a PLL director modulator structure, which is a structure capable of removing a mixer and a digital-to-analog (D/A) converter of a transmitter, has received much attention recently. The biggest advantage of the PLL direct modulator is that it can reduce an area, and the disadvantage thereof is that a high-speed transmission signal is distorted due to characteristics of a PLL low pass filter since data is sent to a PLL loop as an input.

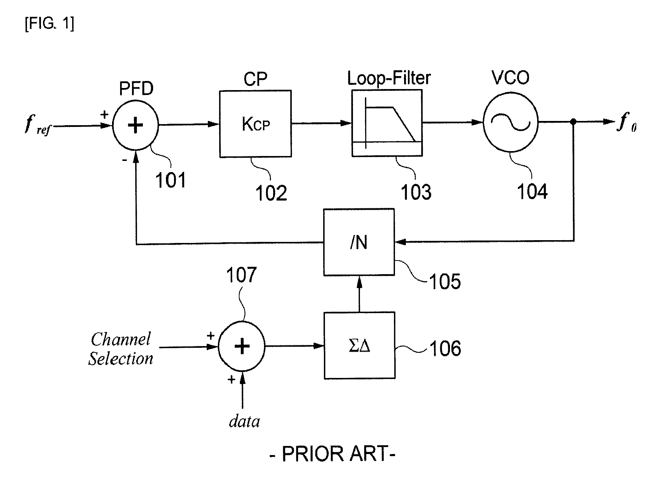

FIG. 1 is a view schematically showing configuration of a conventional one point PLL direct modulator.

Referring to FIG. 1, a conventional PLL direct modulator includes a phase-frequency detector 101 for outputting a synthesized frequency of a reference frequency input through an input terminal and an oscillation frequency from a voltage-controlled oscillator (VCO) 104 which is divided by n by a divider 105 and fed back, a charge pump 102 which receives and pumps the output of the phase-frequency detector 101, a loop-filter 103 which filters the signal passing through the charge pump 102, and the VCO 104 which receives the low-frequency-removed signal by the loop-filter 103 to oscillate a high frequency signal.

The conventional one point PLL direct modulator having the above configuration provides a channel (frequency) and data as the input of the divider 105. However, in the one point PLL direct modulator, there is a problem that the high speed transmission signal is distorted since the input signal (channel) passes through a low pass filter.

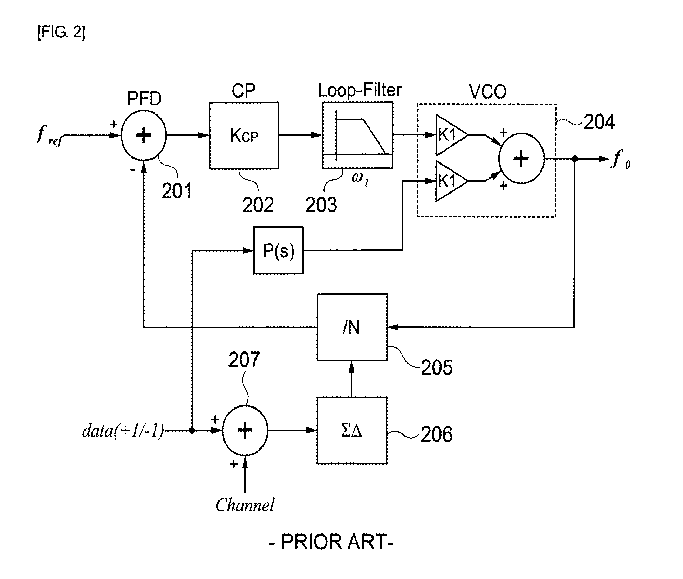

In order to prevent the distortion of the high speed transmission signal, in the prior art, a two point PLL direct modulator is used as shown in FIG. 2.

The two point PLL direct modulator provides data as inputs of a divider 205 (having low pass filter characteristics) and a VCO 204 (having high pass filter characteristics). That is, since the data are provided through two paths and form respective loops, distortion of signals can be reduced by complementary compensation of high/low pass characteristics.

However, the two point PLL modulator should have a means for reducing a gain mismatch since the frequency gain mismatch in the path into the input of the VCO 204 has great influence on error vector magnitude (EVM). In FIGS. 1 and 2, the reference numerals 106 and 206, 107 and 207, 201, 202, and 203 represent a sigma-delta modulator, an adder, a phase-frequency detector, a charge pump, and a loop-filter, respectively.

### [Related Art Document]

### [Patent Document]

Patent Document 1: Japanese Patent Laid-open Publication No. 2011-509047
Patent Document 2: U.S. Patent Laid-open Publication No. US2007-0109067

### SUMMARY OF THE INVENTION

The present invention has been invented in order to overcome the above-described problems and it is, therefore, an object of the present invention to provide a PLL direct modulator that can reduce a frequency gain mismatch by forming a desired channel frequency using a digital divider and a sigma-delta modulator, changing a division ratio through the sigma-delta modulator, and performing frequency modulation through adjustment of a voltage of a second varactor of a voltage-controlled oscillator (VCO), and a frequency gain mismatch compensation method in the modulator.

In accordance with one aspect of the present invention to achieve the object, there is provided a PLL direct modulator including: a phase-frequency detector (PFD) for detecting a frequency-phase difference between a reference frequency and a fed-back divided frequency and providing a pulse according to the detected difference; a charge pump (CP) for outputting a plus (+) or minus (-) current pulse by receiving the pulse from the PFD; a loop filter for converting the current pulse from the CP into a voltage; a VCO for outputting a preset frequency signal by receiving the voltage from the loop filter; a divider for dividing the frequency signal from the VCO into a relatively lower frequency signal; and a sigma-delta modulator for outputting an arbitrary numerical value by receiving a specific value, wherein a frequency gain mismatch compensator is installed between the divider and the VCO to modulate the frequency of the VCO by receiving the frequency signal from the divider and modulation data supplied from the outside.

Here, the frequency gain mismatch compensator may include a gain mismatch calibrator for performing calibration for gain mismatch compensation by receiving the frequency signal divided by the divider; and a resistor array stage for modulating the frequency of the VCO by receiving the modulation data supplied from the outside and the output from the gain mismatch calibrator.

At this time, the gain mismatch calibrator may include a divide-by-16 divider for dividing the frequency signal received from a secondary divide-by-2 divider of a first divider by 16 and a digital counter for calculating a counter value of a preset predetermined frequency by receiving the frequency signal divided by the divide-by-16 divider and the reference frequency signal provided from the outside.

At this time, the gain mismatch calibrator may further include an algorithm module for executing an algorithm for gain mismatch calibration based on the counter value of the preset predetermined frequency calculated by the digital counter.

Further, the resistor array stage may consist of a plurality of resistors connected in series.

Further, the frequency gain mismatch compensator may modulate the frequency of the VCO by adjusting a voltage of a second varactor of the VCO.

Further, the divider may include a first divider for dividing the frequency signal from the VCO into the relatively lower frequency signal; and a second divider for forming a desired frequency signal by receiving the output from the first divider and the output value from the sigma-delta modulator.

At this time, the first divider may consist of a primary divide-by-2 divider for dividing the frequency signal from the VCO by 2 into the relatively lower frequency signal, a divide-by-16 divider for dividing the frequency signal divided by 2 by the primary divide-by-2 divider by 16, and a secondary divide-by-2 divider for dividing the frequency signal divided by 16 by the divide-by-16 divider by 2 again.

Further, the second divider may be a digital multi modulus divider.

Further, in accordance with another aspect of the present invention to achieve the object, there is provided a frequency gain mismatch compensation method in a PLL direct modulator including a frequency gain mismatch compensator, including the steps of: a) calculating a counter value corresponding to a reference frequency by the frequency gain mismatch compensator; b) calculating the current frequency counter value to search a voltage value corresponding to a preset plus frequency by the frequency gain mismatch compensator; c) determining whether a value obtained by subtracting a reference frequency counter value from the current frequency counter value is equal to a preset plus frequency counter value by the frequency gain mismatch compensator; d) storing the voltage value corresponding to the preset plus frequency when the value obtained by subtracting the reference frequency counter value from the current frequency counter value is equal to the preset plus frequency counter value; e) determining whether the value obtained by subtracting the reference frequency counter value from the current frequency counter value is greater than the preset plus frequency counter value and increasing or decreasing a resistor register value according to the result of the determination when the value obtained by subtracting the reference frequency counter value from the current frequency counter value is not equal to the preset plus frequency counter value; f) calculating the current frequency counter value to search a voltage value corresponding to a preset minus frequency by the frequency gain mismatch compensator; g) determining whether a value obtained by subtracting the current frequency counter value from the reference frequency counter value is equal to a preset minus frequency counter value by the frequency gain mismatch compensator; h) storing the voltage value corresponding to the preset minus frequency when the value obtained by subtracting the current frequency counter value from the reference frequency counter value is equal to the preset minus frequency counter value; and i) determining whether the value obtained by subtracting the current frequency counter value from the reference frequency counter value is greater than the preset minus frequency counter value and increasing or decreasing the resistor register value according to the result of the determination when the value obtained by subtracting the current frequency counter value from the reference frequency counter value is not equal to the preset minus frequency counter value.

Here, the resistor register value is increased when the value obtained by subtracting the reference frequency counter value from the current frequency counter value is greater than the preset plus frequency counter value as a result of determining whether the value obtained by subtracting the reference frequency counter value from the current frequency counter value is greater than the preset plus frequency counter value in the step e).

Further, the resistor register value is decreased when the value obtained by subtracting the reference frequency counter value from the current frequency counter value is less than the preset plus frequency counter value as a result of determining whether the value obtained by subtracting the reference frequency counter value from the current frequency counter value is greater than the preset plus frequency counter value in the step e).

Further, the resistor register value is increased when the value obtained by subtracting the current frequency counter value from the reference frequency counter value is greater than the preset minus frequency counter value as a result of determining whether the value obtained by subtracting the current frequency counter value from the reference frequency counter value is greater than the preset minus frequency counter value in the step i).

Further, the resistor register value is decreased when the value obtained by subtracting the current frequency counter value from the reference frequency counter value is less than the preset minus frequency counter value as a result of determining whether the value obtained by subtracting the current frequency counter value from the reference frequency counter value is greater than the preset minus frequency counter value in the step i).

### BRIEF DESCRIPTION OF THE DRAWINGS

These and/or other aspects and advantages of the present general inventive concept will become apparent and more readily appreciated from the following description of the embodiments, taken in conjunction with the accompanying drawings of which:

FIG. 1 is a view schematically showing configuration of a conventional one point PLL direct modulator;

FIG. 2 is a view schematically showing configuration of a conventional two point PLL direct modulator;

FIG. 3 is a view schematically showing configuration of a PLL direct modulator in accordance with an embodiment of the present invention;

FIG. 4 is a view showing internal configuration of a gain mismatch calibrator in the PLL direct modulator shown in FIG. 3;

FIG. 5 is a view showing circuit configuration of a resistor array stage in the PLL direct modulator shown in FIG. 3; and

FIG. 6 is a flowchart showing an execution process of a frequency gain mismatch compensation method in a PLL direct modulator in accordance with the present invention.

### DETAILED DESCRIPTION OF THE PREFERABLE EMBODIMENTS

The terms or words used in the present specification and claims should not be interpreted as being limited to typical or dictionary meanings, but should be interpreted as having meanings and concepts relevant to the technical spirit of the present invention based on the rule according to which an inventor can appropriately define the concept of the term to describe his/her own invention in the best manner.

Throughout the specification, when an element is referred to as "including" another element, it can further include the other element rather than exclude the other element unless the context clearly indicates otherwise. Further, the terms "unit", "module", "apparatus", etc. used in the present specification represent a unit for processing at least one function or operation and may be implemented by hardware, software, or a combination thereof.

Hereinafter, embodiments of the present invention will be described in detail with reference to the accompanying drawings.

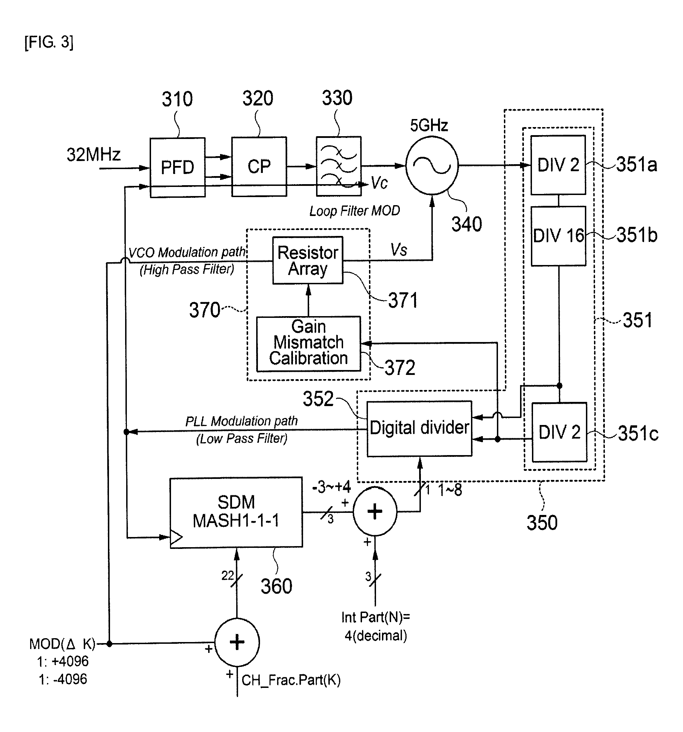

FIG. 3 is a view schematically showing a configuration of a PLL direct modulator in accordance with an embodiment of the present invention.

Referring to FIG. 3, a PLL direct modulator in accordance with the present invention includes a phase-frequency detector (PFD) 310, a charge pump (CP) 320, a loop filter 330, a voltage-controlled oscillator (VCO) 340, a divider 350, a sigma-delta modulator 360, and a frequency gain mismatch compensator 370.

The PFD 310 detects a frequency-phase difference between a reference frequency and a fed-back divided frequency and provides a pulse according to the detected difference.

The CP 320 receives the pulse from the PFD 310 to output a plus (+) or minus (-) current pulse.

The loop filter 330 converts the current pulse from the CP 320 into a voltage. Here, the loop filter 330 may be a low pass filter.

The VCO 340 receives the voltage from the loop filter 330 to output a preset frequency signal.

The divider 350 divides the frequency signal from the VCO 340 to generate a relatively lower frequency signal. Here, the divider 350 may include a first divider 351 which divides the frequency signal from the VCO 340 into a relatively lower frequency signal and a second divider 352 which receives an output from the first divider 351 and an output value from the sigma-delta modulator 360 to form a desired frequency signal.

At this time, the first divider 351 may consist of a primary divide-by-2 divider 351a for dividing the frequency signal from the VCO 340 by 2 to generate a relatively lower frequency signal, a divide-by-16 divider for dividing the frequency signal, which is divided by 2 by the primary divide-by-2 divider 351a, by 16, and a secondary divide-by-2 divider 351c for dividing the frequency signal, which is divided by 16 by the divide-by-16 divider 351b, by 2 again.

Further, the second divider 352 may be a digital multi modulus divider.

The sigma-delta modulator 360 has a function of continuously outputting a varying arbitrary numerical value by receiving a specific value (for example, a specific integer value).

The frequency gain mismatch compensator 370 is installed between the divider 350 and the VCO 340 and modulates the frequency of the VCO 340 by receiving the frequency signal from the divider 350 and modulation data Mod (ΔK) from the outside.

Here, the frequency gain mismatch compensator 370 may include a resistor array stage 371 and a gain mismatch calibrator 372.

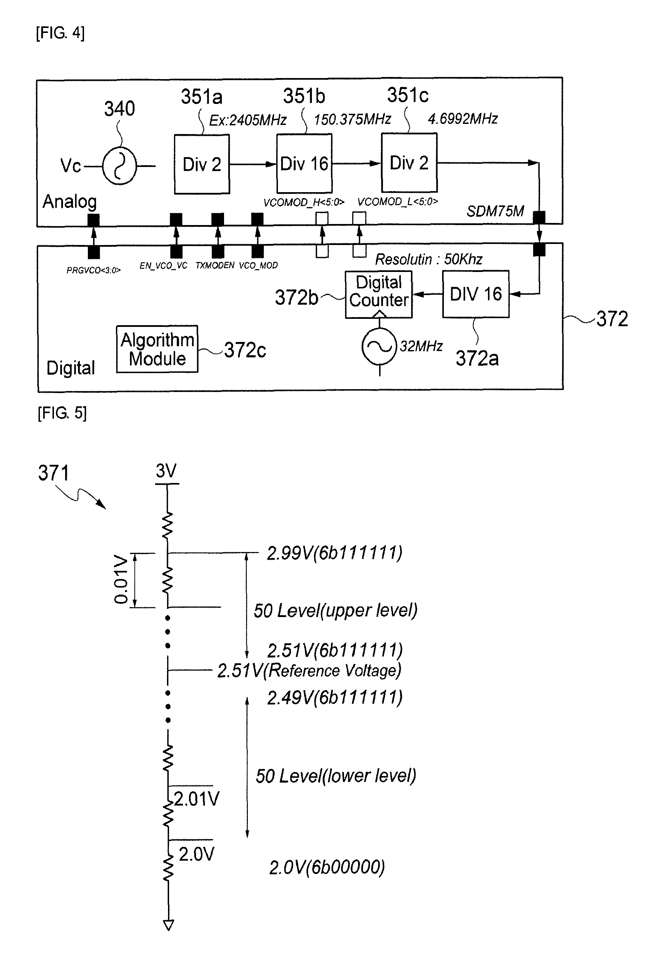

The resistor array stage 371 modulates the frequency of the VCO 340 by receiving the modulation data Mod (ΔK) from the outside and an output from the gain mismatch calibrator 372. At this time, the resistor array stage 371 may consist of a plurality of resistors connected in series as shown in FIG. 5.

The gain mismatch calibrator 372 performs calibration for gain mismatch compensation by receiving the frequency signal divided by the divider 350.

At this time, the gain mismatch calibrator 372 may include a divide-by-16 divider 372a which divides the frequency signal received from the secondary divide-by-2 divider 351c of the first divider 351 by 16 and a digital counter 372b which counts a counter value of a preset predetermined frequency by receiving the frequency signal divided by the divide-by-16 divider 372a and the reference frequency signal provided from the outside.

At this time, further, the gain mismatch calibrator 372 may further include an algorithm module 372c which executes an algorithm for gain mismatch calibration based on the counter value of the preset predetermined frequency calculated by the digital counter 372b.

Further, the frequency gain mismatch compensator 370 may modulate the frequency of the VCO 340 by adjusting a voltage of a second varactor of the VCO 340. That is, the frequency gain mismatch compensator 370 calculates a counter value of 500 kHz, for example, using a digital counter 352b of 32 MHz. Further, the frequency gain mismatch compensator 370 searches the current frequency counter value by receiving the data Mod (ΔK) signal provided from the outside, searches a varactor application voltage of 500 kHz by comparing the current frequency counter value with the counter value of 500 kHz and changing a control signal of the resistor array stage 371, and modulates the frequency of the VCO 340 based on it.

In FIG. 3, the reference numerals "Vc" and "Vs" represent a first varactor input voltage and a second varactor input voltage, respectively.

Then, a frequency gain mismatch compensation method in the PLL direct modulator in accordance with the present invention having the above configuration will be described.

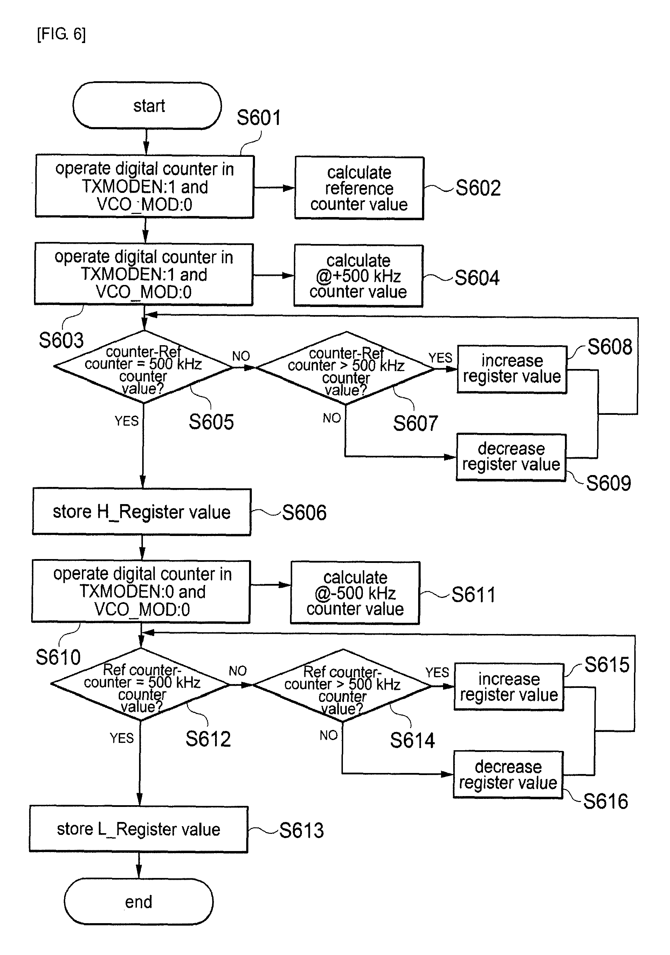

FIG. 6 is a flowchart showing an execution process of a frequency gain mismatch compensation method in a PLL direct modulator in accordance with the present invention.

Referring to FIG. 6, the frequency gain mismatch compensation method in a PLL direct modulator in accordance with the present invention is a frequency gain mismatch compensation method in the above-described PLL direct modulator including a PFD 310, a CP 320, a loop filter 330, a VCO 340, a divider 350, a sigma-delta modulator 360, and a frequency gain mismatch compensator 370. First, a counter value corresponding to a reference frequency is calculated by the frequency gain mismatch compensator 370 (S601 and S602). That is, first of all, the PLL direct modulator of the present invention is changed into an open loop, and an arbitrary control voltage is applied to the PLL modulator to be used as an input voltage of a first varactor of the VCO 340. After that, the counter value corresponding to the reference frequency is calculated after operating a digital counter 372b in a state in which register stages "TXMODEN" and "VCO_MOD" (refer to FIG. 4) of a gain mismatch calibrator 372 are set to 1 and 0, respectively.

When the calculation of the counter value corresponding to the reference frequency is completed in this way, the current frequency counter value is calculated similarly by the frequency gain mismatch compensator 370 to search a voltage value corresponding to a preset plus frequency (for example, +500 kHz) (S603 and S604). That is, the current frequency counter value is calculated after operating the digital counter 372b in a state in which the register stages "TXMODEN" and "VCO_MOD" of the gain mismatch calibrator 372 are set to 1 and 0, respectively.

When the calculation of the current frequency counter value is completed by the above process, the frequency gain mismatch compensator 370 determines whether a value obtained by subtracting a reference frequency counter value from the current frequency counter value is equal to a preset plus frequency counter value (S605).

When the value obtained by subtracting the reference frequency counter value from the current frequency counter value is equal to the preset plus frequency counter value in the determination of the step S605, the voltage value corresponding to the preset plus frequency is stored in a register H_Register (S606).

And, when the value obtained by subtracting the reference frequency counter value from the current frequency counter value isn't equal to the preset plus frequency counter value in the determination of the step S605, it is determined whether the value obtained by subtracting the reference frequency counter value from the current frequency counter value is greater than the preset plus frequency counter value (S607), and a resistor register value is increased or decreased according to the result of the determination.

That is, when the value obtained by subtracting the reference frequency counter value from the current frequency counter value is greater than the preset plus frequency counter value as a result of determining whether the value obtained by subtracting the reference frequency counter value from the current frequency counter value is greater than the preset plus frequency counter value, the resistor register value is increased (S608).

And, when the value obtained by subtracting the reference frequency counter value from the current frequency counter value is less than the preset plus frequency counter value as a result of determining whether the value obtained by subtracting the reference frequency counter value from the current frequency counter value is greater than the preset plus frequency counter value, the resistor register value is decreased (S609).

After that, the current frequency counter value is calculated by the frequency gain mismatch compensator 370 to search a voltage value corresponding to a preset minus frequency (for example, -500 kHz) (S610 and S611). That is, the current frequency counter value is calculated to search the voltage value corresponding to the preset minus frequency after operating the digital counter 372b in a state in which the register stages "TXMODEN" and "VCO_MOD" of the gain mismatch compensator 372 are all set to 0.

When the calculation of the current frequency counter value is completed in the step S611, the frequency gain mismatch compensator 370 determines whether a value obtained by subtracting the current frequency counter value from the reference frequency counter value is equal to a preset minus frequency counter value (S612).

When the value obtained by subtracting the current frequency counter value from the reference frequency counter value is equal to the preset minus frequency counter value in the determination of the step S612, the voltage value corresponding to the preset minus frequency is stored in a register L_Register (S613).

And, when the value obtained by subtracting the current frequency counter value from the reference frequency counter value isn't equal to the preset minus frequency counter value in the determination of the step S612, it is determined whether the value obtained by subtracting the current frequency counter value from the reference frequency counter value is greater than the preset minus frequency counter value (S614), and the resistor register value is increased or decreased according to the result of the determination.

That is, when the value obtained by subtracting the current frequency counter value from the reference frequency counter value is greater than the preset minus frequency counter value as a result of determining whether the value obtained by subtracting the current frequency counter value from the reference frequency counter value is greater than the preset minus frequency counter value in the step S614, the resistor register value is increased (S615).

And, when the value obtained by subtracting the current frequency counter value from the reference frequency counter value is less than the preset minus frequency counter value as a result of determining whether the value obtained by subtracting the current frequency counter value from the reference frequency counter value is greater than the preset minus frequency counter value in the step S614, the resistor register value is decreased (S616).

Like the above, it is possible to modulate the frequency of the VCO 340 by searching the current frequency counter value, comparing the current frequency counter value with the counter value of the preset predetermined frequency (500 kHz), and searching the varactor application voltage of the VCO 340 through increase or decrease in resistance of the resistor array stage 371, thereby compensating a frequency gain mismatch.

As in the above description, the PLL direct modulator in accordance with the present invention can reduce a frequency gain mismatch in a PLL modulator by forming a desired channel frequency using a digital divider and a sigma-delta modulator, compensating the frequency gain mismatch through a frequency gain mismatch compensator, and performing frequency modulation through adjustment of a voltage of a second varactor of a VCO.

Although the preferable embodiments of the present invention have been described in detail above, the present invention is not limited to the embodiments and it will be appreciated by those skilled in the art that various modifications and applications may be made in the embodiments without departing from the technical spirit of the present invention. Therefore, the range of protection of the present invention should be interpreted from the appended claims and all technical sprits within the range equivalent to the range should be interpreted as being included in the range of the rights of the present invention.

## Claims

1. A PLL direct modulator comprising:
a phase-frequency detector (PFD) for detecting a frequency-phase difference between a reference frequency and a fed-back divided frequency and providing a pulse according to the detected difference;
a charge pump (CP) for outputting a plus (+) or minus (-) current pulse by receiving the pulse from the PFD;
a loop filter for converting the current pulse from the CP into a voltage;
a voltage-controlled oscillator (VCO) for outputting a preset frequency signal by receiving the voltage from the loop filter;
a divider for dividing the frequency signal from the VCO into a relatively lower frequency signal; and
a sigma-delta modulator for outputting an arbitrary numerical value by receiving a specific value, wherein a frequency gain mismatch compensator is installed between the divider and the VCO to modulate the frequency of the VCO by receiving the frequency signal from the divider and modulation data supplied from the outside.

2. The PLL direct modulator according to claim 1, wherein the frequency gain mismatch compensator comprises:
a gain mismatch calibrator for performing calibration for gain mismatch compensation by receiving the frequency signal divided by the divider; and
a resistor array stage for modulating the frequency of the VCO by receiving the modulation data supplied from the outside and the output from the gain mismatch calibrator.

3. The PLL direct modulator according to claim 2, wherein the gain mismatch calibrator comprises:
a divide-by-16 divider for dividing the frequency signal received from a secondary divide-by-2 divider of a first divider by 16; and
a digital counter for calculating a counter value of a preset predetermined frequency by receiving the frequency signal divided by the divide-by-16 divider and the reference frequency signal provided from the outside.

4. The PLL direct modulator according to claim 3, wherein the gain mismatch calibrator further comprises an algorithm module for executing an algorithm for gain mismatch calibration based on the counter value of the preset predetermined frequency calculated by the digital counter.

5. The PLL direct modulator according to claim 2, wherein the resistor array stage consists of a plurality of resistors connected in series.

6. The PLL direct modulator according to claim 1, wherein the frequency gain mismatch compensator modulates the frequency of the VCO by adjusting a voltage of a second varactor of the VCO.

7. The PLL direct modulator according to claim 1, wherein the divider comprises:
a first divider for dividing the frequency signal from the VCO into a relatively lower frequency signal; and
a second divider for forming a desired frequency signal by receiving the output from the first divider and the output value from the sigma-delta modulator.

8. The PLL direct modulator according to claim 7, wherein the first divider consists of a primary divide-by-2 divider for dividing the frequency signal from the VCO by 2 into a relatively lower frequency signal, a divide-by-16 divider for dividing the frequency signal divided by 2 by the primary divide-by-2 divider by 16, and a secondary divide-by-2 divider for dividing the frequency signal divided by 16 by the divide-by-16 divider by 2 again.

9. The PLL direct modulator according to claim 7, wherein the second divider is a digital multi modulus divider.

10. A frequency gain mismatch compensation method in a PLL direct modulator comprising a frequency gain mismatch compensator, comprising:
a) calculating a counter value corresponding to a reference frequency by the frequency gain mismatch compensator;
b) calculating the current frequency counter value to search a voltage value corresponding to a preset plus frequency by the frequency gain mismatch compensator;
c) determining whether a value obtained by subtracting a reference frequency counter value from the current frequency counter value is equal to a preset plus frequency counter value by the frequency gain mismatch compensator;
d) storing the voltage value corresponding to the preset plus frequency when the value obtained by subtracting the reference frequency counter value from the current frequency counter value is equal to the preset plus frequency counter value;
e) determining whether the value obtained by subtracting the reference frequency counter value from the current frequency counter value is greater than the preset plus frequency counter value and increasing or decreasing a resistor register value according to the result of the determination when the value obtained by subtracting the reference frequency counter value from the current frequency counter value is not equal to the preset plus frequency counter value;
f) calculating the current frequency counter value to search a voltage value
corresponding to a preset minus frequency by the frequency gain mismatch compensator;
g) determining whether a value obtained by subtracting the current frequency counter value from the reference frequency counter value is equal to a preset minus frequency counter value by the frequency gain mismatch compensator;
h) storing the voltage value corresponding to the preset minus frequency when the value obtained by subtracting the current frequency counter value from the reference frequency counter value is equal to the preset minus frequency counter value; and
i) determining whether the value obtained by subtracting the current frequency counter value from the reference frequency counter value is greater than the preset minus frequency counter value and increasing or decreasing the resistor register value according to the result of the determination when the value obtained by subtracting the current frequency counter value from the reference frequency counter value is not equal to the preset minus frequency counter value.

11. The frequency gain mismatch compensation method according to claim 10, wherein the resistor register value is increased when the value obtained by subtracting the reference frequency counter value from the current frequency counter value is greater than the preset plus frequency counter value as a result of determining whether the value obtained by subtracting the reference frequency counter value from the current frequency counter value is greater than the preset plus frequency counter value in the step e).

12. The frequency gain mismatch compensation method according to claim 10,
wherein the resistor register value is decreased when the value obtained by subtracting the reference frequency counter value from the current frequency counter value is less than the preset plus frequency counter value as a result of determining whether the value obtained by subtracting the reference frequency counter value from the current frequency counter value is greater than the preset plus frequency counter value in the step e).

13. The frequency gain mismatch compensation method according to claim 10, wherein the resistor register value is increased when the value obtained by subtracting the current frequency counter value from the reference frequency counter value is greater than the preset minus frequency counter value as a result of determining whether the value obtained by subtracting the current frequency counter value from the reference frequency counter value is greater than the preset minus frequency counter value in the step i).

14. The frequency gain mismatch compensation method according to claim 10, wherein the resistor register value is decreased when the value obtained by subtracting the current frequency counter value from the reference frequency counter value is less than the preset minus frequency counter value as a result of determining whether the value obtained by subtracting the current frequency counter value from the reference frequency counter value is greater than the preset minus frequency counter value in the step i).
